(19) Europäisches Patentamt / European Patent Office / Office européen des brevets

(11) **EP 2 522 041 B1**

(12) **EUROPEAN PATENT SPECIFICATION**

(45) Date of publication and mention
of the grant of the patent:
**23.04.2014 Bulletin 2014/17**

(51) Int Cl.:
***H01L 45/00*** *(2006.01)*

(21) Application number: **11700200.6**

(22) Date of filing: **06.01.2011**

(86) International application number:
**PCT/GB2011/050009**

(87) International publication number:
**WO 2011/083327 (14.07.2011 Gazette 2011/28)**

(54) **ELECTRICALLY ACTUATED SWITCH**

ELEKTRISCH BETÄTIGTER SCHALTER

COMMUTATEUR À COMMANDE ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.01.2010 GB 201000192**

(43) Date of publication of application:
**14.11.2012 Bulletin 2012/46**

(73) Proprietor: **DNA Electronics Ltd
London W12 7SB (GB)**

(72) Inventors:
• **PRODROMAKIS, Themistoklis
London WC1N 2EB (GB)**
• **TOUMAZOU, Christofer
London WC1N 2EB (GB)**
• **MICHELAKIS, Konstantios
London WC1N 2EB (GB)**

(74) Representative: **Lind, Robert
Marks & Clerk LLP
Fletcher House
Heatley Road
The Oxford Science Park
Oxford OX4 4GE (GB)**

(56) References cited:
**US-A1- 2008 278 990    US-A1- 2009 272 435**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to an electrically actuated switch and methods of manufacturing an electrically actuated switch. The invention is applicable in particular, though not necessarily, to memristors and their manufacture.

Background

The memory-resistor or "memristor" is a passive two-terminal circuit element that maintains a functional relationship between the time integrals of current and voltage. Such a device was originally predicted by L.O. Chua in the article, "memristor-The missing circuit element" (1971). In 2008, Hewlett Packard disclosed a memristor switch having a top and a bottom electrode and an active region comprising a TiO2/TiO2-x bi-layer. Such devices have enormous potential for non-volatile memory applications and neurally-inspired circuits, while they are likely to lend a much needed life extension to Moore's law.

The observed memristive effect is believed to be due to charge displacement within a mainly insulating, nanoscale thickness layer of active material. In the initial Hewlett Packard devices, the active charge was shown to be oxygen vacancies within a $TiO_2$ layer. These vacancies tended to gather on one side of the active layer, depending on the applied bias, leaving the opposite side purely stoichiometric. Later, Hewlett Packard employed direct deposition of $TiO_2$ layers and they introduced positively charged oxygen vacancies $TiO_{2-x}$ by a temperature-annealing step. In a technologically much simpler implementation, a 60-nm-thick amorphous $TiO_2$ active layer was directly achieved by spinning a $TiO_2$ sol gel, with the resulting devices exhibiting electrical switching with memory characteristics that are consistent with the electrical behaviour expected of memristors.

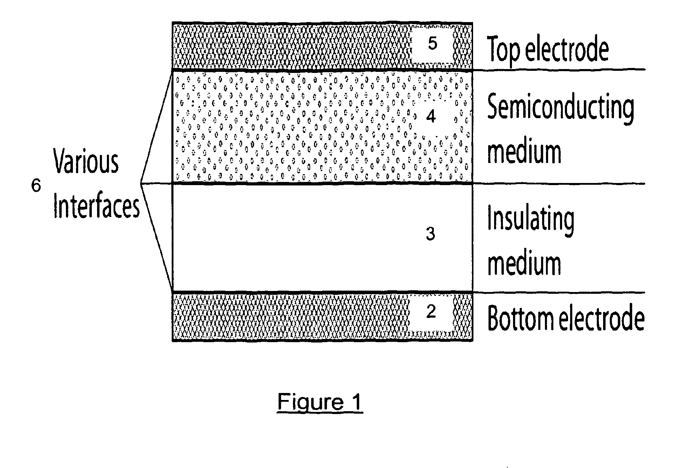

A memristor structure is illustrated schematically in Figure 1. This comprises two electrodes 2,5 with an active region disposed in between. This active region 3 entails at least one material for hosting and transporting ions and another material 4 for providing a source/sink of ionic dopants (see Figure 1). Application of a relatively high biasing voltage to the electrodes causes the displacement of ions within the active region, forming disparate semiconducting 4 and insulating regions 3, which are maintained when the biasing is ceased. However, if the device is subjected to a bias of reversed polarity, the mobile ions move towards their initial position with the overall resistivity of the device modulated accordingly. The state of the active region can be "read" using a relatively low voltage, insufficient to move ions within the active region.

The device's ability to remember the last resistive state is due to the permanent displacement of charge under a DC bias and is empirically considered to be proportional to the inverse square of the layer thickness within which the charge is mobile. Clearly, this effect is substantially large in nanoscale devices, explaining why this behaviour had not been given much attention earlier.

The memory effect of the memristor can be mathematically described by:

$$M(q) = \frac{d\phi/dt}{dq/dt} = \frac{V(t)}{I(t)} = M(q(\tau)) \qquad (1)$$

For a varying charge q, memristance $M(q(_T))$ depends on the previous "state" of the device, $M(q(\tau\text{-}t))$. However, at a given moment $\tau 0$, the instantaneous (static) memristance $M(q(\tau 0))$ of the device is its resistivity, as in a resistor. Likewise, if q is zero, then $M(q(t))$ is a constant, which can be considered to be a distinct case of Ohm's law.

Ideally a memristor could be characterised in the generalised form of Ohm's law:

$$\mathbf{J_1} = \sigma(\varepsilon_1)\mathbf{E_1} \qquad (2)$$

where J1 is the current density at a given location, E1 is the electric field at that location and $\sigma(\varepsilon 1)$ is the conductivity of the material. Equation 2 is particularly interesting in that non-linearity can be introduced by considering an anisotropic material. So far, all existing memristors depend upon a step charge distribution within the active region, by employing two or more layers, each with different ion concentrations.

The quality of the interfaces 6 between layers within a memristor plays a significant role in the charge displacement, which defines the memristance of the device. Thus the manufacturing method used is of great importance for achieving reliable devices with repeatable characteristics. In previous manufacturing implementations, various layers are deposited at high vacuum, but in transferring between the different process steps required for manufacturing each layer, the interfaces 6 (i.e. the interfaces between the two electrodes and the active layer as well as the interfaces existing within the different regions of the active layer) are inevitably exposed to an ambient air environment. This approach could result in unwanted interfacial states that could potentially "screen" any applied bias, compromising the device's intrinsic characteristics.

The following references provide background to memristor structures, properties, and fabrication methods:

L.O. Chua, "memristor-The missing circuit element", IEEE Trans. on Circuits Theory, vol. CT-18, no. 5, pp. 507 - 519, Sep 1971.

L.O. Chua and S.M. Kang, "Memristive Devices and Systems", Proc. of the IEEE, vol. 64, no. 2, pp. 209-223, Feb 1976.
Qiangfei Xia et al, "Fabrication of Nanoscale Memristor Arrays with One Nanoimprint Lithography Step", published on the WWW at "http://www.eipbn.org/data/papers/5A-4.pdf"
R.S. Williams, "Multi-terminal Electrically actuated switch", US2008/0079029, Apr. 3, 2008.
R.S. Williams, "Electrically actuated switch", US2008/0090337, Apr. 17, 2008.
J. Yang, M.D. Pickett, X. Li, D.A.A. Ohlberg, D.R. Stewart and R.S. Williams, "Memristive switching mechanism for metal/oxide/metal nanodevices", Nature Nanotech., vol. 3, pp. 429-433, Jul 2008.
M.J. Rozenberg, I.H. Inoue, and M.J. Sanchez, "Nonvolatile Memory with Multilevel Switching: A Basic Model", Physical Review Letters, vol. 92, no. 17, Apr 2004.
B. Linares-Barranco and T. Serrano-Gotarredona, "Memristance can explain Spike-Time-Dependent-Plasticity in Neural Synapses", Nature Precedings, Mar 2009.
B.L. Moutett, "memristor crossbar neural interface", US2009/0163826, Jun. 25, 2009.
R. Williams, "How We Found The Missing memristor", Spectrum, IEEE, vol. 45, 2008, pp. 28-35.
N. Gergel-Hackett, B. Hamadani, B. Dunlap, J. Suehle, C. Richter, C. Hacker, and D. Gundlach, A flexible solution-processed memristor, IEEE Electron Device Lett., vol. 30, no. 7, pp. 706708, 2009.
Nadine Gergel-Hackett, "Nonvolatile memory device and processing method", US2009/0184397.
N. Gergel-Hackett, B. Hamadani, C.A. Richter, D.J. Gundlach, "Non-volatile memory device and processing method", US2009/0184397, Jul. 23, 2009.
Patent document US2008/278990.
Patent document US2009/272435.

Summary

The present inventors have appreciated that it is possible to avoid the above manufacturing deficiencies with a novel process that also reduces the number and complexity of the steps. Hence costs can be reduced and quality can be improved.
According to a first aspect of the invention there is provided a method of manufacturing an electrically actuable switch and comprising depositing a first electrode on a surface;
depositing an active layer or layers on top of said first electrode; and depositing a second electrode on top of said active layer(s). The step of depositing an active layer or layers is performed in an atmosphere into which a reactive gas is introduced, the partial pressure of the reactive gas being varied during the process so as to introduce dopants into the active layer in a concentration which varies across the active layer.
According to a second aspect of the invention there is provided a method of manufacturing an electrically actuable switch and comprising depositing a first electrode on top of a surface; depositing a first active layer on top of said first electrode; depositing a second active layer on top of said first active layer; and depositing a second electrode on top of said second active layer. The first and second active layers are deposited using respective different source materials, and the deposition steps are carried out within a single chamber without removing the switch from the chamber.
Further preferred aspects of the invention are set out in the accompanying dependent claims.

Brief Description of the Drawings

Figure 1 is an illustration of a known memristor structure;
Figure 2 is an illustration of a manufacturing process according to an embodiment of the invention;
Figure 3 is an illustration of a manufacturing process according to an alternative embodiment;
Figure 4 is an illustration of a deposition process using two source materials;
Figure 5 is an illustration of a cross-section of a memristor having a stepped dopant profile;
Figure 6 is an illustration of a cross-section of a memristor having a continuously varying dopant profile;

Figure 7 shows an exemplary manufacturing technique showing a double-layer photoresist and the angle evaporation principle

Figure 8 is a graph of memristor characteristics, fabricated according to an embodiment of the invention showing current-voltage characteristics (a) in detail over a reduced range (b) over the entire tested range; and

Figure 9 is a graph of memristor, characteristics, fabricated according to an alternative embodiment of the invention showing current-voltage characteristics (a) in detail over a reduced range (b) over the entire tested range.

Detailed description

The following presents a new method for fabricating an electrically actuated switch having, for example, applications as a memristor. As discussed above, a memristor is a device having at least a region or layer capable of hosting and transporting dopants and at least a second region or layer for providing the dopants. In contrast with previous manufacturing techniques which deposit the second region from a single material that contains the dopants or adds a material to remove dopants, the method described here deposits the second region from either a mixture of differently doped materials or a mixture of a material and an environment containing dopants. The two methods of mixing and depositing the second region may also be combined. Embodiments of the method allow all layers to be deposited using a single manufacturing process, thus removing the need for intermediate steps which add complexity and may expose the materials to oxidation. Such a method thus lends itself to continuous manufacturing.

In one embodiment, the process is carried out with a single lithographic step. This could be realized in various ways such as: optical lithography, electron-beam lithography, nano-imprint lithography or substrate conformal imprint lithography.

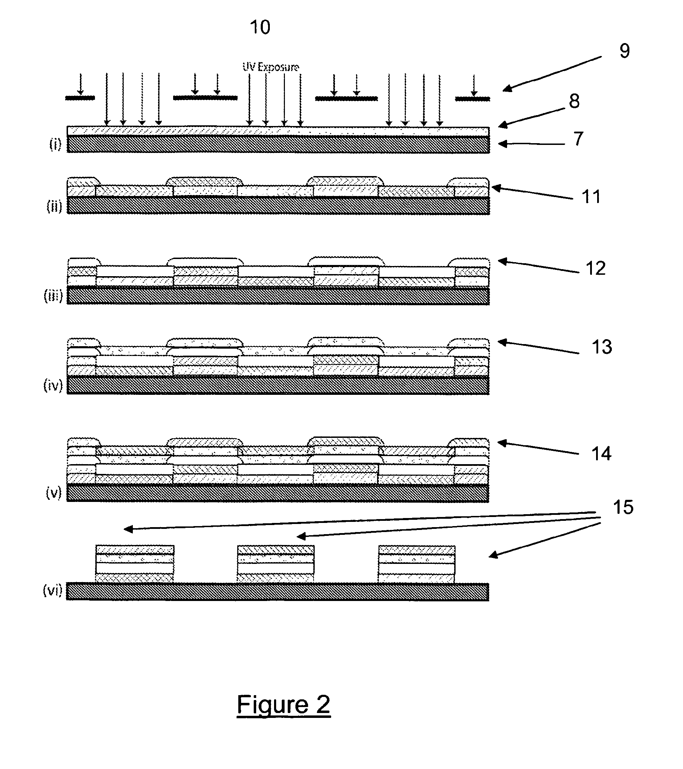

An example of such a process is illustrated in Figure 2, and is described as follows:

I. A photo-resist layer 8 is laid down on a substrate 7 and is exposed through a mask 9 to UV light 10. Development of the resist removes certain portions of the photo-resist;

II. A bottom electrode 11 is deposited;

III. A first material is deposited in an environment containing an inert gas (such as Argon) to create the first active region 12;

IV. The same or different material is deposited in an environment where a reactive gas is present (such as Oxygen) to create the second active region 13;

V. A top electrode 14 is deposited.

VI. Lift-off removes material above the extant photo-resist to reveal the final memristor devices 15.

The deposition of all layers can be performed at room temperature, with no need for a temperature-annealing step as described in previous techniques. Each sub-layer can be of any thickness from a few nanometres (nm) to a micrometer.

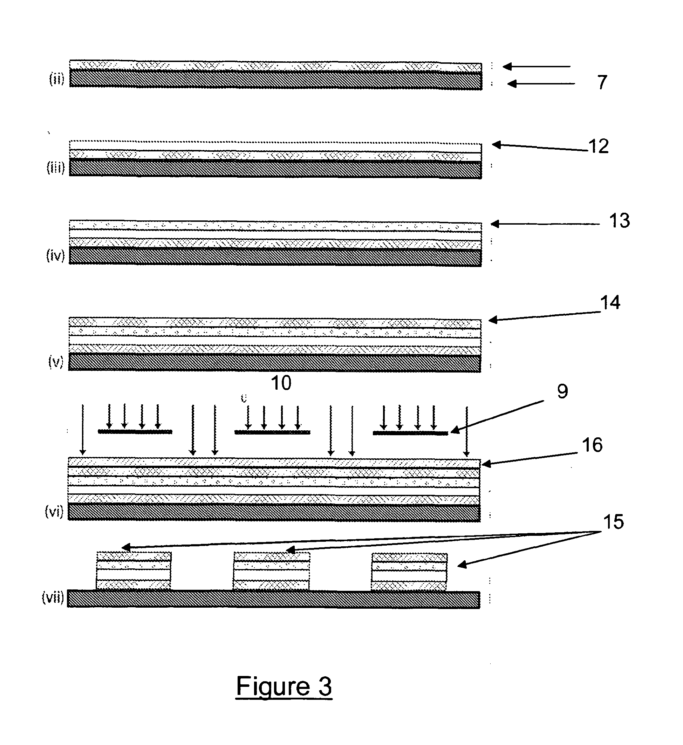

A variation of the process described above is shown in Figure 3, where a masking layer 16 is laid down as a final layer, subsequently patterned using for example photolithography, and an etchant used to remove the undesired portions.

The process may take place in a high-vacuum chamber. For example, the chamber may initially be at $10^{-7}$ mbar for the deposition of the electrode. During the deposition of the active regions 12,13, the pressure may increase to $2\times10^{-2}$ mbar as the inert and/or reactive gas is introduced. In one exemplary embodiment, the Argon flow is 12 SCCM (standard cubic centimeters per minute) for step iii above, becoming 12 SCCM of $O_2$ during step iv above.

Deposition of materials may be done with any suitable technique, such as: electron beam evaporation, Knudsen Cell evaporation, RF sputtering from a target material, as well as other known chemical vapour deposition methods. The thickness of the first active region 12 may range from 1 nm to 100nm and the range of the second region 13 may be the same. In one embodiment, the thickness is 75nm for the whole active region 12,13.

Whilst previous devices have been limited to the nanometer scale because the memristance effect was believed to decrease with the square of active region thickness, using devices manufactured according to the processes described here it has been found that the memristance effect is even present on a micro-scale and varies with the volume of the active region. Thus memristors having larger cross-sectional areas are possible by compensating with a very thin film active region. For example a memristor may be made having plan-view dimension of 50 micrometers x 50 micrometers, for a cross-sectional area of 2500 square micrometers. Memristors with plan-view dimensions of only a few nanometers have also been made.

In an alternative embodiment, the process of fabricating the active layer illustrated in Figure 2 at step (iv) is:

iv. Depositing material for the second region 13 concurrently from two or more materials, at least one of which provides a dopant species.

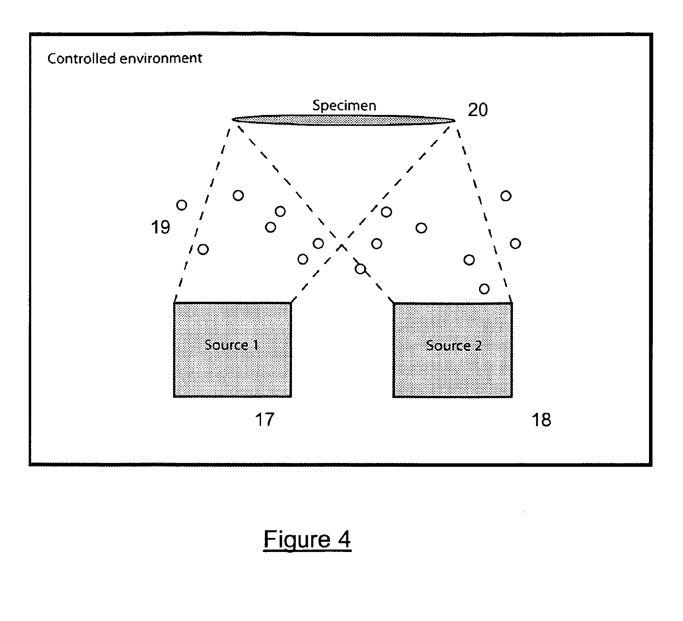

Figure 4 illustrates deposition of the second region from two source materials 17,18, with the specimen identified by reference numeral 20. In an exemplary embodiment, the first source material 17 is $TiO_2$ and the second source material 18 is $TiO_{2+x}$ (where "x" represents a fractional amount of extra oxygen atoms per $TiO_2$ structure), the resulting second region being a mixture of the two materials having a net excess of $O_2$ ions. In general, the combined utilisation of two or more source materials, one of which is conductive, results in the deposition of a composite layer that will contain conductive defects. Furthermore the concentration of the defects will depend on the relative concentration of the source materials which can be controlled by the deposition method.

It is also possible to reverse the order of the deposition of the first and second regions. For example, the dopant-rich second region 13 may be deposited before the dopant-free first region 12.

It is also possible to combine the techniques described above to create a second region from two or more source materials deposited in an environment where a reactive gas 19, for example oxygen, is present. The resulting concentration of dopants in this region will depend on the ratio of source materials and the partial pressure of the reactive gas.

From the foregoing description of the fabrication of the first and second regions, it is possible to manufacture an electrically actuated switch having an active layer with two distinct regions with a dopant step-change interface therebetween or an active region with a continuously varying doping distribution.

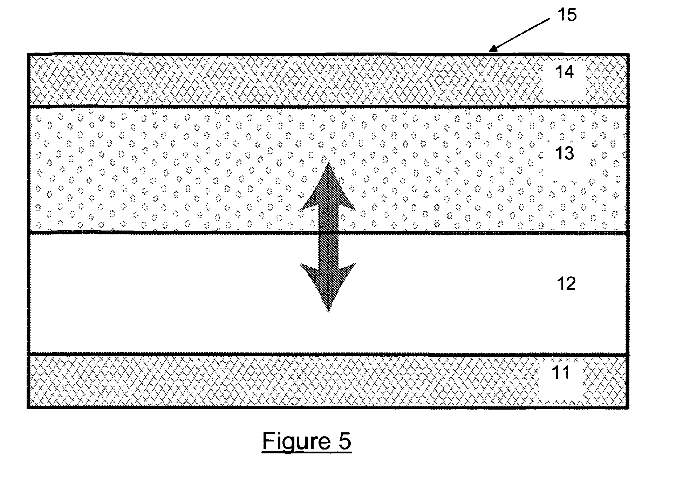

Figure 5 is an illustration of a cross-section of an electrically actuated switch manufactured using a $TiO_2$ source target and an oxygen-rich environment. The switch has a step change in dopants within the active layer, creating a $TiO_2$ sub-layer 12 and $TiO_{2+x}$ sublayer 13. The arrows indicate the displacement of the mobile charge on the upper layer, depending on the applied biasing. Such a switch is manufactured using the process above where there is a step change in the source materials and/or the environment.

In one embodiment for fabricating the active layer of an electrically actuated switch, deposition of the active layer material begins in an environment where an inert gas is initially present. The flow is gradually reduced and at the same time the flow of a reactive gas (such as Oxygen) is gradually increased.

In another embodiment for fabricating the active layer of an electrically actuated switch, deposition of the active layer material begins with a first material (e.g. an insulator). The rate of deposition of the first material is gradually reduced and, at the same time, the rate of deposition of a second material (e.g. conductive material) is gradually increased.

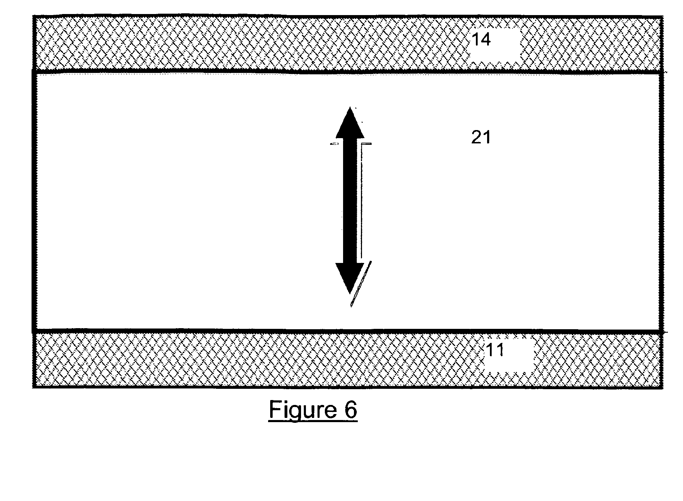

Figure 6 is an illustration of a cross-section of an electrically actuated switch manufactured using the novel technique. In contrast to Figure 5, there is no step-change in dopant concentration. Rather, this switch has an active layer 21 where the relative $TiO_2/TiO_{2+x}$ ratio changes substantially continuously across the device. The distribution may vary linearly or non-linearly depending on the characteristics desired. The arrows indicate the displacement of the mobile charge on the upper layer, according to the applied biasing.

Since manufacturing is performed in an (initially) evacuated chamber, the individual interfaces are exposed to controlled gases in controlled amounts instead of air, thus resulting in greater control over the interface quality and greater consistency in device characteristics.

In principle, the primary material for the first region can be any source material for depositing a material that acts as a host for the ions. A list of potential primary materials is summarised in Table 1. Similarly a secondary material (used in the case of depositing two source materials for the second region) may be any material which provides a dopant species. A list of potential secondary materials is also summarised in Table 1. It is also possible to choose a mixture of primary materials for the first region and/or a mixture of primary materials and secondary materials for the second region.

The dopant species that results from the secondary material or reactive gas is listed also in Table 1. The reactive gas is any gas that contributes a dopant species by reacting with the primary or secondary material to create a new material with an excess of the dopants. For example, Oxygen, Nitrogen or Fluorine may be used. In contrast, the inert gas does not contribute a dopant and does not react with the primary or secondary material. For example, Argon, Neon, Xenon or Krypton may be used.

The following describes in more detail a method of manufacturing memristors, having two variants. These involve the use of a deposition chamber that includes both electron-gun and RF-sputtering evaporation sources and employs contact optical lithography and lift-off for depositing the platinum electrodes and the titanium oxide switching layers. More specifically, the top and bottom electrodes consist of electron-gun evaporated Ti/Pt bilayers with respective thicknesses of 5 and 15 nm. The switching layers consists of two successive 30nm-thick titanium-oxide layers, sputtered off a stoichiometric TiO2 target at a pressure of 1.8x10-2 mbar and a RF (13.56 MHz) power density of 8 W/cm2. The first region is deposited in the presence of 12 SCCM flow of Argon gas and the second region is deposited in the presence of 12 SCCM flow of Oxygen gas.

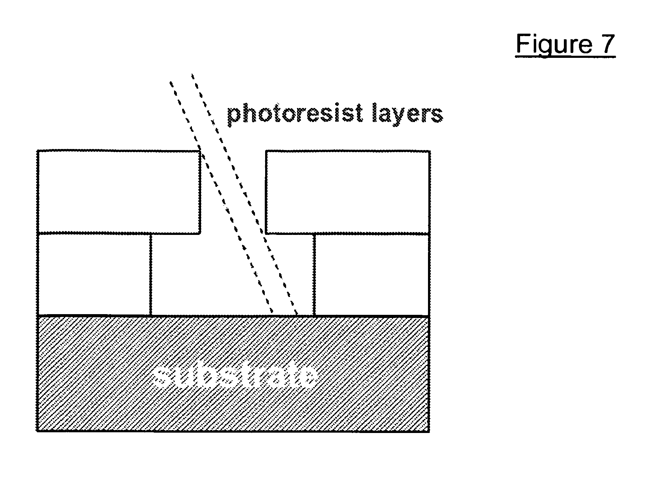

Two distinct fabrication approaches have been tested using the above conditions. The first one involved deposition of the bottom memristor electrode together with the switching layers in a single lithography and lift-off step. The top intersecting electrode was then fabricated following a second lithography, evaporation and lift-off process. Both these lithographic steps were performed by using an enhanced photoresist profile consisting of a double layer of sub-micron resolution positive photoresist (AZ 5214 E, Clariant). In more detail, the first layer was flood-exposed prior to the spinning of the second layer, followed by exposure of the desired pattern through a photomask and subsequent development of both layers. As a result of this process, an undercut was formed in the first layer as shown in Figure 7, the extent of which can be reproducibly controlled by varying the development time.

According to this process, whilst the top layer can retain a dimension close to the nominal value, an undercut of over six microns can be formed within the bottom resist layer. This process makes it possible to lift-off sputter-evaporated layers, something not usually achievable with standard photoresist profiles, given the conformal step coverage of sputter deposition. Importantly, the resulting undercut profile can also be used to shrink electrode width towards nanoscale dimensions, if required, by employing angle evaporation, as shown in Figure 7. In this case, the undercut in the photoresist profile, apart from facilitating lift-off, also serves to accommodate the offsets required to shrink electrode lateral dimensions. By using angle evaporation in combination with the enhanced photoresist profile, it is possible to shrink electrode lateral dimensions controllably to below 100 nm.

A second memristor fabrication technique approach involves the deposition of the whole active stack (top and bottom electrodes and switching layers) in a single lithography and evaporation step, without exposing the unfinished device to ambient conditions, leading to high-quality interfaces with reproducibly controlled characteristics. In more detail, a Ti/Au contact pad is first made on a silicon substrate, onto which the whole stack is deposited via lift-off in a single lithography step. Then, a silicon nitride passivating layer is sputter-deposited and a window etched to uncover the memristor stack as well as the contact pad. Finally, a second contact pad is deposited onto the silicon nitride layer to provide a connection to the top end of the memristor stack.

The first fabrication approach described above offers a cost-effective method of realising memristors by using standard photolithography and lift-off. These devices can be used for characterisation purposes as well as for integration up to a moderate density. As the method is compatible with the angle evaporation technique, it is possible to shrink electrode width down to under 100nm without resorting to expensive tools. The device stack has to be exposed to ambient prior to the completion of the fabrication process, which may be a concern with regard to the quality and reproducibility of the interfaces. However, this interruption is designed to occur at the top interface, involving an oxygen-rich titanium oxide layer and the titanium layer of the memristor top electrode.

The second fabrication approach also uses standard lithography and lift-off but offers higher interface quality, as the whole of the device stack is deposited in one continuous step without exposure to ambient conditions. The same method can be combined with Nanoimprint lithography to yield reliable nanoscale devices.

Memristors, fabricated with both processing approaches described above, have been characterised. DC current-voltage measurements were performed "on-wafer" by contacting the top and bottom device electrodes with a pair of Wentworth probes, connected with a Keithley 4200 Semiconductor Characterisation System. Since the properties of the devices are dependent upon their previous state, the measurement procedure was of great significance. Thus, all devices were initially biased at the maximum negative voltage (-5V), then the applied bias was ramped up to the maximum voltage of 5V in 50mV, 1 ms long steps and finally back to -5V again, in the same manner. For device protection purposes, current limiting to +/- 100mA was applied throughout all measurements.

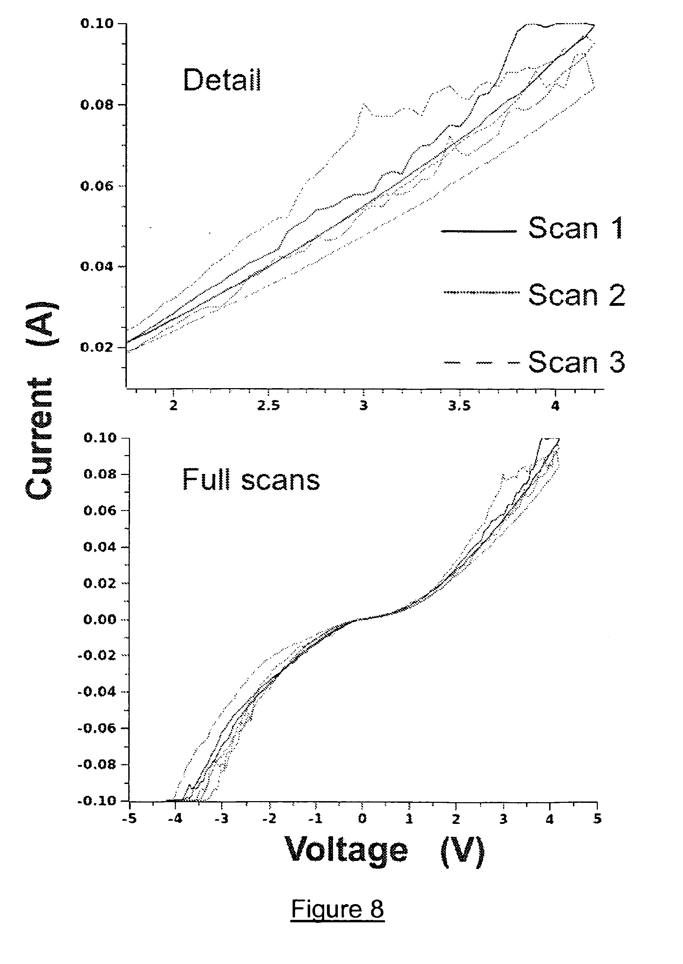

Typical current-voltage characteristics of 1 $\mu$m x 1 $\mu$m memristors, fabricated with the first approach described above, are shown in the graphs of Figure 8 (with Figure 8A illustrating a detail of the graph of Figure 8A). Transition from a high-resistance state (off state) to a low resistance state (on state) occurs at a bias of around +/- 1 V. Furthermore, there is an evident broadening of the hysteresis loop after each consecutive scan (three scans are illustrated in Figure 8).

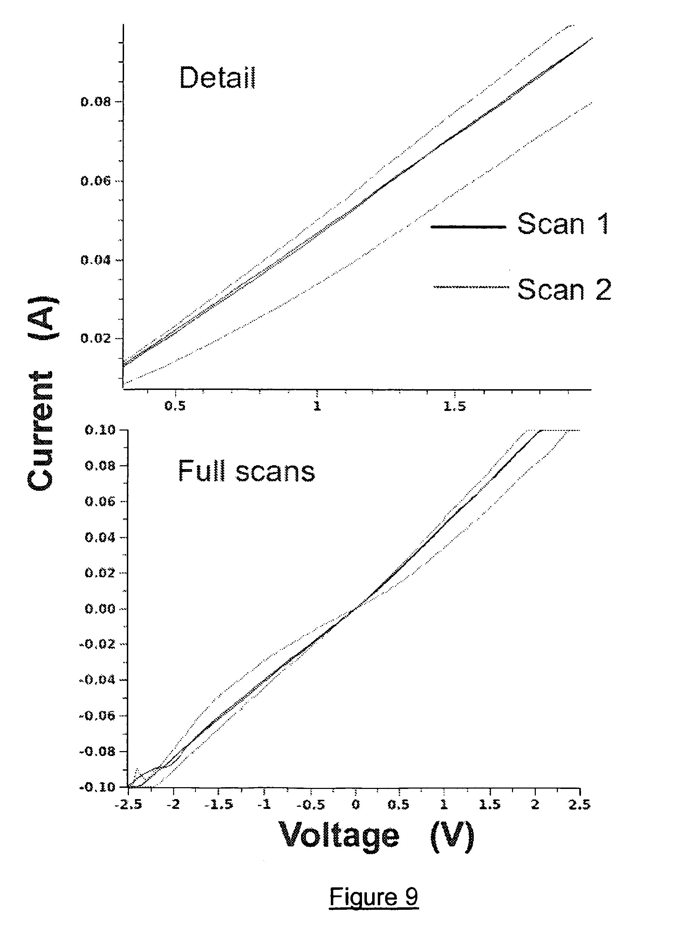

Similar memristive response was also observed on devices fabricated with the second method, as shown in the graphs of Figure 9 (for which two scans are illustrated). In this case, the device cross-section was 5$\mu$m x 5$\mu$m and perhaps this was the reason that transition from an off to an on state is not as clear as in the devices of the first technique. However, the broadening of the hysteresis loop after the second scan is more pronounced and the characteristic curves for all scans are smoother, suggesting a better quality device core.

These techniques make it possible to realise the full active stack in one continuous step and to controllably shrink the memristor electrodes towards nanoscale width dimensions in a cost-effective way. Devices of various dimensions have been fabricated and characterised. DC current-voltage measurements show reproducible electrical response that is consistent with memristive behaviour.

The non-linear dynamics of the memristor as well as its "plasticity" are properties that resemble the chemical synapse and have recently attracted significant interest within the "neuromorphic" community. Artificial synaptic networks could in principle imitate the way the human brain functions, particularly the processing and storing of information perceived by the body's sensory network. Thus, networks comprising high-densities of interconnected memristors have great potential for imitating the large number of synapses between neighbouring neurons.

TABLE 1

*List of Potential materials for the active regions and the resulting dopant species.*

| Primary Material | Secondary Material | Dopant Species |
|---|---|---|
| $TiO_2$ | $TiO_{2+x}$ | Oxygen excess |
| $ZrO_2$ | $ZrO_{2+x}$ | Oxygen excess |
| $HfO_2$ | $HfO_{2+x}$ | Oxygen excess |
| $SrTiO_3$ | $SrTiO_{3+x}$ | Oxygen excess |

Although the invention has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims.

**Claims**

1.  A method of manufacturing an electrically actuable switch and **characterised by** comprising:

    depositing a first electrode (11) on a surface;
    depositing an active layer or layers (12, 13, 21) on top of said first electrode;
    and
    depositing a second electrode (14) on top of said active layer(s) (12, 13, 21), wherein said step of depositing an active layer or layers (12, 13, 21) is performed in an atmosphere into which a reactive gas is introduced, the partial pressure of the reactive gas being varied during the process so as to introduce dopants into the active layer (12, 13, 21) in a concentration which varies across the active layer (12, 13, 21).

2.  A method according to claim 1 and comprising varying the partial pressure of the reactive gas from substantially zero to some pressure greater than zero in a substantially stepwise manner during the deposition of the active layer (12, 13, 21) so as to produce a substantially stepwise change in the concentration of dopants in the active layer (12, 13, 21) or varying the partial pressure of the reactive gas in a substantially continuously varying manner during the deposition of the active layer (12, 13, 21) so as to produce a substantially continuously varying change in the concentration of dopants in the active layer (12, 13, 21) between the electrodes (11, 14) and wherein said continuously varying change in the concentration of dopants in the active layer (12, 13, 21) between the electrodes (11, 14) may be linear.

3.  A method according to any one of the preceding claims, wherein the step of depositing an active layer (12, 13, 21) comprises depositing material originating from a single source material or depositing material originating from two or more source materials in order to deposit a multi-layer active region (12, 13, 21).

4.  A method according to any one of the preceding claims and comprising performing at least a part of said step of depositing an active layer (12, 13, 21) in an atmosphere containing a substantially non-reactive gas.

5.  A method according to claim 4 wherein said substantially non-reactive gas is one of argon, neon, xenon and krypton.

6.  A method according to any one of the preceding claims, wherein all of the steps are performed within a single chamber without removing the switch from the chamber during the process.

7.  A method according to any one of the preceding claims, wherein said reactive gas is one of oxygen, nitrogen, and fluorine.

8.  A method according to any one of the preceding claims, wherein the step of depositing an active layer (12, 13, 21) comprises depositing an oxide of titanium, zirconium, hafnium, strontium-titanium, or silicon, with the reactive gas being introduced so as to vary the concentration of oxygen ions across the active layer (12, 13, 21) or wherein the step of depositing an active layer (12, 13, 21) comprises depositing a nitride of gallium, with the reactive gas being introduced so as to vary the concentration of nitrogen ions across the active layer (12, 13, 21).

9. A method according to any one of the preceding claims, wherein the step of depositing an active layer (12, 13, 21) comprises RF sputtering evaporation, electron gun evaporation, or Knudsen Cell evaporation.

10. A method of manufacturing an electrically actuable switch and comprising:

depositing a first electrode (11) on top of a surface;
depositing a first active layer (12) on top of said first electrode (11);
depositing a second active layer (13) on top of said first active layer; and
depositing a second electrode (14) on top of said second active layer (13), said first and second active layers (12, 13) being deposited using respective different source materials, and **characterised in that** the deposition steps being carried out within a single chamber without removing the switch from the chamber.

11. A method according to claim 10, wherein said different source materials are oxides or nitrides having different concentrations of oxygen or nitrogen, respectively.

12. A method of manufacturing an electrically actuable switch and **characterised by** comprising:

depositing a first electrode (11) on a surface;
depositing a first active layer (12) on top of said first electrode (11);
depositing a second active layer (13) on top of said first active layer (12); and
depositing a second electrode (14) on top of said second active layer (13), the method further comprising depositing a doping layer between said first electrode (11) and said first active layer (12) or between said second electrode (14) and said second active layer (13), whereby ionic dopants from the doping layer penetrate the first or second active layer (12, 13) to dope that layer.

13. A method according to any one of the preceding claims, wherein the steps of depositing said first and second electrodes (11, 14) comprises depositing bi-layers of platinum and titanium.

14. An electrically actuable switch manufactured using the method of any one of the preceding claims.

15. An electrically actuable switch according to claim 14, wherein said active layer (12, 13, 21) is an oxide of titanium and said ionic dopant is oxygen.

**Patentansprüche**

1. Verfahren zur Herstellung eines elektrisch betätigbaren Schalters, **dadurch gekennzeichnet, dass** es umfasst:

Abscheiden einer ersten Elektrode (11) auf einer Oberfläche;
Abscheiden einer aktiven Schicht oder aktiver Schichten (12, 13, 21) auf der ersten Elektrode; und
Abscheiden einer zweiten Elektrode (14) auf der bzw. den aktiven Schicht(en) (12, 13, 21), worin der Schritt des Abscheidens einer aktiven Schicht oder aktiver Schichten (12, 13, 21) in einer Atmosphäre durchgeführt wird, in die ein reaktives Gas eingeführt wird, wobei der Partialdruck des reaktiven Gases während des Prozesses variiert wird, um dadurch Dotanden in die aktive Schicht (12, 13, 21) einzuführen, und zwar in einer Konzentration, die über die aktive Schicht (12, 13, 21) variiert.

2. Verfahren nach Anspruch 1 und umfassend: Variieren des Partialdrucks des reaktiven Gases von im Wesentlichen null zu einem Druck größer als null, und zwar auf eine im Wesentlichen schrittweise Weise während der Abscheidung der aktiven Schicht (12, 13, 21), um dadurch eine im Wesentlichen schrittweise Änderung in der Konzentration von Dotanden in der aktiven Schicht (12, 13, 21) zu erzeugen, oder Variieren des Partialdrucks des reaktiven Gases auf eine im Wesentlichen kontinuierlich variierende Weise während der Abscheidung der aktiven Schicht (12, 13, 21), um dadurch eine im Wesentlichen kontinuierlich variierende Änderung in der Konzentration von Dotanden in der aktiven Schicht (12, 13, 21) zwischen den Elektroden (11, 14) zu erzeugen, und worin die kontinuierlich variierende Änderung in der Konzentration von Dotanden in der aktiven Schicht (12, 13, 21) zwischen den Elektroden (11, 14) linear sein kann.

3. Verfahren nach einem der vorhergehenden Ansprüche, worin der Schritt des Abscheidens einer aktiven Schicht (12, 13, 21) umfasst: Abscheiden von Material, das aus einem einzigen Quellmaterial stammt, oder Abscheiden von Material, das aus zwei oder mehr Quellmaterialien stammt, um eine aktive Mehrschichtregion (12, 13, 21) abzuscheiden.

4. Verfahren nach einem der vorhergehenden Ansprüche und umfassend: Durchführen zumindest eines Teils des Schritts des Abscheidens einer aktiven Schicht (12, 13, 21) in einer Atmosphäre, die ein im Wesentlichen nichtreaktives Gas enthält.

5. Verfahren nach Anspruch 4, worin das im Wesentlichen nichtreaktive Gas eines von Folgendem ist: Argon, Neon, Xenon und Krypton.

6. Verfahren nach einem der vorhergehenden Ansprüche, worin alle Schritte innerhalb einer einzigen Kammer durchgeführt werden, ohne den Schalter während des Prozesses aus der Kammer zu entfernen.

7. Verfahren nach einem der vorhergehenden Ansprüche, worin das reaktive Gas eines von Folgendem ist: Sauerstoff, Stickstoff und Fluor.

8. Verfahren nach einem der vorhergehenden Ansprüche, worin der Schritt des Abscheidens einer aktiven Schicht (12, 13, 21) umfasst: Abscheiden eines Oxids von Titan, Zirkonium, Hafnium, Strontium-Titan oder Silizium, wobei das reaktive Gas eingeführt wird, um dadurch die Konzentration von Sauerstoffionen über die aktive Schicht (12, 13, 21) zu variierten; oder worin der Schritt des Abscheidens einer aktiven Schicht (12, 13, 21) umfasst: Abscheiden eines Nitrids von Gallium, wobei das reaktive Gas eingeführt wird, um dadurch die Konzentration von Stickstoffionen über die aktive Schicht (12, 13, 21) zu variieren.

9. Verfahren nach einem der vorhergehenden Ansprüche, worin der Schritt des Abscheidens einer aktiven Schicht (12, 13, 21) umfasst: Hochfrequenzsputter-Verdampfung, Elektronenstrahl-Verdampfung oder Knudsenzellen-Verdampfung.

10. Verfahren zur Herstellung eines elektrisch betätigbaren Schalters, umfassend:

Abscheiden einer ersten Elektrode (11) auf einer Oberfläche;
Abscheiden einer ersten aktiven Schicht (12) auf der ersten Elektrode (11);
Abscheiden einer zweiten aktiven Schicht (13) auf der ersten aktiven Schicht; und
Abscheiden einer zweiten Elektrode (14) auf der zweiten aktiven Schicht (13), wobei die erste und zweite aktive Schicht (12, 13) unter Verwendung unterschiedlicher Quellmaterialien abgeschieden werden, und **dadurch gekennzeichnet, dass** die Abscheidungsschritte innerhalb einer einzigen Kammer durchgeführt werden, ohne den Schalter aus der Kammer zu entfernen.

11. Verfahren nach Anspruch 10, worin die unterschiedlichen Quellmaterialien Oxide oder Nitride mit unterschiedlichen Konzentrationen von Sauerstoff bzw. Stickstoff sind.

12. Verfahren zur Herstellung eines elektrisch betätigbaren Schalters, **dadurch gekennzeichnet, dass** es umfasst:

Abscheiden einer ersten Elektrode (11) auf einer Oberfläche;
Abscheiden einer ersten aktiven Schicht (12) auf der ersten Elektrode (11);
Abscheiden einer zweiten aktiven Schicht (13) auf der ersten aktiven Schicht; und
Abscheiden einer zweiten Elektrode (14) auf der zweiten aktiven Schicht (13),
wobei das Verfahren ferner umfasst: Abscheiden einer Dotierungsschicht zwischen der ersten Elektrode (11) und der ersten aktiven Schicht (12) oder zwischen der zweiten Elektrode (14) und der zweiten aktiven Schicht (13), wodurch ionische Dotanden aus der Dotierungsschicht in die erste oder zweite aktive Schicht (12, 13) eindringen, um diese Schicht zu dotieren.

13. Verfahren nach einem der vorhergehenden Ansprüche, worin die Schritte des Abscheidens der ersten und der zweiten Elektrode (11, 14) umfassen: Abscheiden von Doppelschichten aus Platin und Titan.

14. Elektrisch betätigbarer Schalter, hergestellt unter Verwendung des Verfahrens nach einem der vorhergehenden Ansprüche.

15. Elektrisch betätigbarer Schalter nach Anspruch 14, worin die aktive Schicht (12, 13, 21) ein Oxid von Titan ist und der ionische Dotand Sauerstoff ist.

**Revendications**

1. Procédé de fabrication d'un commutateur actionnable électriquement et **caractérisé en ce qu'**il comprend :

   le dépôt d'une première électrode (11) sur une surface ;
   le dépôt d'une couche ou de couches actives (12, 13, 21) sur ladite première électrode ; et
   le dépôt d'une deuxième électrode (14) sur ladite ou lesdites couches actives (12, 13, 21), dans lequel ladite étape de dépôt d'une couche ou de couches actives (12, 13, 21) est effectuée dans une atmosphère dans laquelle un gaz réactif est introduit, la pression partielle du gaz réactif étant modifiée pendant le processus de manière à introduire des dopants dans la couche active (12, 13, 21) en une concentration qui varie dans la couche active (12, 13, 21).

2. Procédé selon la revendication 1 et comprenant la modification de la pression partielle du gaz réactif sensiblement de zéro à une certaine pression supérieure à zéro d'une manière sensiblement par pas pendant le dépôt de la couche active (12, 13, 21) de manière à produire une variation sensiblement par pas de la concentration de dopants dans la couche active (12, 13, 21) ou la modification de la pression partielle du gaz réactif d'une manière sensiblement continue pendant le dépôt de la couche active (12, 13, 21) de manière à produire une variation sensiblement continue de la concentration de dopants dans la couche active (12, 13, 21) entre les électrodes (11, 14), et dans lequel ladite variation continue de la concentration de dopants dans la couche active (12, 13, 21) entre les électrodes (11, 14) peut être linéaire.

3. Procédé selon l'une quelconque des revendications précédentes, dans lequel l'étape de dépôt d'une couche active (12, 13, 21) comprend le dépôt d'un matériau provenant d'un matériau de source unique ou le dépôt d'un matériau provenant de deux matériaux de source ou plus afin de déposer une région active multicouche (12, 13, 21).

4. Procédé selon l'une quelconque des revendications précédentes et comprenant l'exécution d'au moins une partie de ladite étape de dépôt d'une couche active (12, 13, 21) dans une atmosphère contenant un gaz sensiblement non réactif.

5. Procédé selon la revendication 4, dans lequel ledit gaz sensiblement non réactif est l'un de l'argon, du néon, du xénon et du krypton.

6. Procédé selon l'une quelconque des revendications précédentes, dans lequel toutes les étapes sont effectuées dans une chambre unique sans retirer le commutateur de la chambre pendant le processus.

7. Procédé selon l'une quelconque des revendications précédentes, dans lequel ledit gaz réactif est l'un de l'oxygène, de l'azote et du fluor.

8. Procédé selon l'une quelconque des revendications précédentes, dans lequel l'étape de dépôt d'une couche active (12, 13, 21) comprend le dépôt d'un oxyde de titane, de zircone, d'hafnium, de strontium-titane, ou de silicium, le gaz réactif étant introduit de manière à modifier la concentration d'ions d'oxygène dans la couche active (12, 13, 21) ou dans lequel l'étape de dépôt d'une couche active (12, 13, 21) comprend le dépôt d'un nitrure de gallium, le gaz réactif étant introduit de manière à modifier la concentration d'ions d'azote dans la couche active (12, 13, 21).

9. Procédé selon l'une quelconque des revendications précédentes, dans lequel l'étape de dépôt d'une couche active (12, 13, 21) comprend une évaporation par pulvérisation radiofréquence, une évaporation par canon à électrons, ou une évaporation par cellule de Knudsen.

10. Procédé de fabrication d'un commutateur actionnable électriquement et comprenant :

    le dépôt d'une première électrode (11) sur une surface ;
    le dépôt d'une première couche active (12) sur ladite première électrode (11) ;
    le dépôt d'une deuxième couche active (13) sur ladite première couche active ; et
    le dépôt d'une deuxième électrode (14) sur ladite deuxième couche active (13), lesdites première et deuxième couches actives (12, 13) étant déposées en utilisant différents matériaux de source respectifs, et **caractérisé**

**en ce que** les étapes de dépôt sont effectuées dans une chambre unique sans retirer le commutateur de la chambre.

11. Procédé selon la revendication 10, dans lequel lesdits différents matériaux de source sont des oxydes ou des nitrures ayant différentes concentrations d'oxygène ou d'azote, respectivement.

12. Procédé de fabrication d'un commutateur actionnable électriquement et **caractérisé en ce qu'**il comprend :

le dépôt d'une première électrode (11) sur une surface ;
le dépôt d'une première couche active (12) sur ladite première électrode (11) ;
le dépôt d'une deuxième couche active (13) sur ladite première couche active (12) ; et
le dépôt d'une deuxième électrode (14) sur ladite deuxième couche active (13),
le procédé comprenant en outre le dépôt d'une couche de dopage entre ladite première électrode (11) et ladite première couche active (12) ou entre ladite deuxième électrode (14) et ladite deuxième couche active (13), moyennant quoi des dopants ioniques provenant de la couche de dopage pénètrent dans la première ou la deuxième couche active (12, 13) pour doper cette couche.

13. Procédé selon l'une quelconque des revendications précédentes, dans lequel les étapes de dépôt desdites première et deuxième électrodes (11, 14) comprennent le dépôt de doubles couches de platine et de titane.

14. Commutateur actionnable électriquement fabriqué en utilisant le procédé selon l'une quelconque des revendications précédentes.

15. Commutateur actionnable électriquement selon la revendication 14, dans lequel ladite couche active (12, 13, 21) est un oxyde de titane et ledit dopant ionique est l'oxygène.

Figure 1

10

UV Exposure

(i)

9

8

7

(ii)

11

(iii)

12

(iv)

13

(v)

14

15

(vi)

## Figure 2

## Figure 3

Controlled environment

Specimen 20

19

Source 1    Source 2

17    18

## Figure 4

Figure 5

Figure 6

Figure 7

photoresist layers

substrate

Figure 8

Figure 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20080079029 A
- US 20080090337 A
- US 20090163826 A
- US 20090184397 A
- US 2008278990 A
- US 2009272435 A

### Non-patent literature cited in the description

- **L.O. CHUA.** memristor-The missing circuit element. Hewlett Packard, 1971
- **L.O. CHUA.** memristor-The missing circuit element. *IEEE Trans. on Circuits Theory,* September 1971, vol. CT-18 (5), 507-519
- **L.O. CHUA ; S.M. KANG.** Memristive Devices and Systems. *Proc. of the IEEE,* February 1976, vol. 64 (2), 209-223
- **QIANGFEI XIA et al.** *Fabrication of Nanoscale Memristor Arrays with One Nanoimprint Lithography Step, WWW at ''http://www.eipbn.org/data/papers/5A-4.pdf*
- **J. YANG ; M.D. PICKETT ; X. LI ; D.A.A. OHLBERG ; D.R. STEWART ; R.S. WILLIAMS.** Memristive switching mechanism for metal/oxide/metal nanodevices. *Nature Nanotech.,* July 2008, vol. 3, 429-433
- **M.J. ROZENBERG ; I.H. INOUE ; M.J. SANCHEZ.** Nonvolatile Memory with Multilevel Switching: A Basic Model. *Physical Review Letters,* April 2004, vol. 92 (17
- **B. LINARES-BARRANCO ; T. SERRANO-GOTARREDONA.** Memristance can explain Spike-Time-Dependent-Plasticity in Neural Synapses. *Nature Precedings,* March 2009
- **R. WILLIAMS.** How We Found The Missing memristor. *Spectrum,* 2008, vol. 45, 28-35
- **N. GERGEL-HACKETT ; B. HAMADANI ; B. DUNLAP ; J. SUEHLE ; C. RICHTER ; C. HACKER ; D. GUNDLACH.** A flexible solution-processed memristor. *IEEE Electron Device Lett.,* 2009, vol. 30 (7), 706708